# EUROPEAN PATENT APPLICATION

(11) **EP 4 141 683 A1**
(43) Date of publication of application: **01.03.2023**
(21) Application number: 21863703.1
(22) Date of filing: 03.09.2021
(51) Int. Cl.: G06F 13/10

(54) **DATA SIGNAL PROCESSING METHOD AND APPARATUS FOR EMBEDDED MULTIMEDIA CARD (EMMC)**

(30) Priority: 03.09.2020 CN 202010917560
(71) Applicant: Guangzhou Xiaopeng Motors Technology Co., Ltd., Guangzhou, Guangdong 510000 (CN)
(72) Inventor: HU, Guozhen, Guangzhou, Guangdong 510000 (CN)
(74) Representative: Ran, Handong
(86) International application number: PCT/CN2021/116468
(87) International publication number: WO 2022/048641

(57) **Abstract**

Provided are a data signal processing method and an apparatus for an eMMC. The method includes: acquiring a first CMD signal and a second CMD signal, and a first DATA signal and a second DATA signal, transmitted between the eMMC and a preset electronic chip; determining a CMD write signal and a CMD read signal from among the first CMD signal and the second CMD signal; measuring Tr values of the CMD write signal and the CMD read signal, and Tr values of the first DATA signal and the second DATA signal; determining a DATA write signal and a DATA read signal from among the first DATA signal and the second DATA signal based on the Tr values of the CMD write signal and the CMD read signal; and separating out the DATA write signal and the DATA read signal. The method does not need to parse content of data by using logic analysis functions of consistency analysis software to determine directions of the DATA signals and is thus simple, efficient, and cost-effective.

## Description

The present application claims the priority of CN Application No. 202010917560.9 filed on 3 September 2020 and entitled "DATA SIGNAL PROCESSING METHOD AND APPARATUS FOR EMBEDDED MULTIMEDIA CARD (EMMC)", the content of which is herein incorporated by reference in its entirety.

### Field of the Invention

The present disclosure relates to the technical field of signal processing, and in particular to a data signal processing method and apparatus for an embedded multimedia card (eMMC).

### Background

An eMMC (Embedded Multi Media Card) is an embedded storage system consisting of a multimedia card (MMC) interface, a flash memory, and a host controller. In an eMMC, clock signals (CLK signals) are unidirectional, and bidirectional command/response signals (CMD signals) and bidirectional data signals (DATA signals) are bidirectional. In actual measurement, it is necessary to determine input and output directions of a DATA signal in order to accurately measure parameters in the input and output directions.

At present, read and write timing parameters can be measured with the aid of oscilloscope consistency analysis software. Oscilloscope consistency analysis software integrates logic analysis functions which can be used to determine whether a current direction of a DATA signal is for read or write by parsing a CLK signal and a CMD signal. This method however requires simultaneous measurement of three signals (CLK signal, CMD signal, DATA signal), which requires much effort. Furthermore, optional accessories for the oscilloscope consistency analysis software need to be additionally purchased at a high price.

### Summary

Directed against the above problems, embodiments of the present disclosure are proposed to provide a data signal processing method for an embedded multimedia card (eMMC) so as to overcome or at least partially solve these problems.

The embodiments of the present disclosure further provide a data signal processing apparatus for an eMMC to implement the above method.

To solve the above problems, the embodiments of the present disclosure provide a data signal processing method for an eMMC. The eMMC is connected with a preset electronic chip. The method includes the following steps:
acquiring a first bidirectional command/response signal (CMD signal) and a second CMD signal transmitted between the eMMC and the preset electronic chip, and acquiring a first bidirectional data signal (DATA signal) and a second DATA signal transmitted between the eMMC and the preset electronic chip;
determining a CMD write signal and a CMD read signal from among the first CMD signal and the second CMD signal;
measuring a rise time value (Tr value) of the CMD write signal and a Tr value of the CMD read signal, and measuring a Tr value of the first DATA signal and a Tr value of the second DATA signal;
determining a DATA write signal and a DATA read signal from among the first DATA signal and the second DATA signal based on the Tr value of the CMD write signal and the Tr value of the CMD read signal; and
separating out the DATA write signal and the DATA read signal.

Optionally, the step of determining a DATA write signal and a DATA read signal from among the first DATA signal and the second DATA signal based on the Tr value of the CMD write signal and the Tr value of the CMD read signal includes:
determining, from among the first DATA signal and the second DATA signal, that the one with the greater Tr value is the DATA write signal and the one with the smaller Tr value is the DATA read signal, when the Tr value of the CMD write signal is greater than the Tr value of the CMD read signal; and
determining, from among the first DATA signal and the second DATA signal, that the one with the greater Tr value is the DATA read signal and the one with the smaller Tr value is the DATA write signal, when the Tr value of the CMD read signal is greater than the Tr value of the CMD write signal.

Optionally, the step of determining a CMD write signal and a CMD read signal from among the first CMD signal and the second CMD signal includes:
determining that the first CMD signal is the CMD write signal when a second bit in a frame structure of the first CMD signal is 1;
determining that the first CMD signal is the CMD read signal when the second bit in the frame structure of the first CMD signal is 0;
determining that the second CMD signal is the CMD write signal when a second bit in a frame structure of the second CMD signal is 1; and
determining that the second CMD signal is the CMD read signal when the second bit in the frame structure of the second CMD signal is 0.

Optionally, the step of separating out the DATA write signal and the DATA read signal includes:
separating out the DATA write signal and the DATA read signal by means of slope triggering of an oscilloscope so as to obtain the DATA write signal and the DATA read signal separately.

The embodiments of the present disclosure further provide a data signal processing apparatus for an eMMC. The eMMC is connected with a preset electronic chip. The apparatus includes:
a signal acquisition module, configured to acquire a first CMD signal and a second CMD signal transmitted between the eMMC and the preset electronic chip, and acquire a first DATA signal and a second DATA signal transmitted between the eMMC and the preset electronic chip;
a CMD signal determination module, configured to determine a CMD write signal and a CMD read signal from among the first CMD signal and the second CMD signal;
a signal measurement module, configured measure a Tr value of the CMD write signal and a Tr value of the CMD read signal, and measure a Tr value of the first DATA signal and a Tr value of the second DATA signal;
a DATA signal determination module, configured to determine a DATA write signal and a DATA read signal from among the first DATA signal and the second DATA signal based on the Tr value of the CMD write signal and the Tr value of the CMD read signal; and
a DATA signal separation module, configured to separate out the DATA write signal and the DATA read signal.

Optionally, the DATA signal determination module includes:
a first DATA signal determination sub-module, configured to determine, from among the first DATA signal and the second DATA signal, that the one with the greater Tr value is the DATA write signal and the one with the smaller Tr value is the DATA read signal, when the Tr value of the CMD write signal is greater than the Tr value of the CMD read signal; and
a second DATA signal determination sub-module, configured to determine, from among the first DATA signal and the second DATA signal, that the one with the greater Tr value is the DATA read signal and the one with the smaller Tr value is the DATA write signal, when the Tr value of the CMD read signal is greater than the Tr value of the CMD write signal.

Optionally, the CMD signal determination module includes:
a first CMD signal determination sub-module, configured to determine that the first CMD signal is the CMD write signal when a second bit in a frame structure of the first CMD signal is 1;
a second CMD signal determination sub-module, configured to determine that the first CMD signal is the CMD read signal when the second bit in the frame structure of the first CMD signal is 0;
a third CMD signal determination sub-module, configured to determine that the second CMD signal is the CMD write signal when a second bit in a frame structure of the second CMD signal is 1; and
a fourth CMD signal determination sub-module, configured to determine that the second CMD signal is the CMD read signal when the second bit in the frame structure of the second CMD signal is 0.

Optionally, the DATA signal separation module includes:
a first DATA signal separation sub-module, configured to separate out the DATA write signal; and
a second DATA signal separation sub-module, configured to separate out the DATA read signal.

The embodiments of the present disclosure further provide an electronic device including a memory and one or more programs. The one or more programs are stored in the memory and are configured to be executed by one or more processors to implement the data signal processing method for the eMMC according to any of the embodiments of the present disclosure.

The embodiments of the present disclosure further provide a readable storage medium. When instructions in the storage medium are executed by a processor of an electronic device, the electronic device is caused to implement the data signal processing method for the eMMC according to any of the embodiments of the present disclosure.

Compared with the existing technologies, the embodiments of the present disclosure have the following advantages.

In the embodiments of the present disclosure, a first CMD signal and a second CMD signal transmitted between an eMMC and a preset electronic chip may be obtained, and a first DATA signal and a second DATA signal transmitted between the eMMC and the preset electronic chip may be obtained. A CMD write signal and a CMD read signal are then determined from among the first CMD signal and the second CMD signal. After Tr values of the CMD write signal and the CMD read signal are measured and Tr values of the first DATA signal and the second DATA signal are measured, a DATA write signal and a DATA read signal are determined from among the first DATA signal and the second DATA signal based on the Tr values of the CMD write signal and the CMD read signal. Finally, the DATA write signal and the DATA read signal are separated out. In the embodiments of the present disclosure, it is not necessary to parse the content of the data by using logic analysis functions of paid consistency analysis software in order to determine the directions of the DATA signals. The embodiments of the present disclosure thus have advantages of being simple, efficient, and cost-effective.

### Brief Description of the Drawings

For a clearer illustration of technical solutions in the embodiments of the present disclosure, the following gives a brief introduction to drawings needed in the description of the embodiments. It is evident that the drawings referred to in the following description only illustrate some embodiments of the present disclosure. For those of ordinary skill in the art, other drawings can be obtained on the basis of these drawings without any creative work.
Fig. 1 is a flowchart of a data signal processing method for an eMMC according to the present disclosure.
Fig. 2 is a simplified signal flow graph of the eMMC of the present disclosure.
Fig. 3 is a schematic diagram of a frame structure of a CMD signal of the present disclosure.
Fig. 4 is a schematic diagram of measuring a Tr value of a CMD write signal in the present disclosure.
Fig. 5 is a schematic diagram of measuring a Tr value of a CMD read signal in the present disclosure.
Fig. 6 is a schematic diagram of measuring a Tr value of a first DATA signal in the present disclosure.
Fig. 7 is a schematic diagram of measuring a Tr value of a second DATA signal in the present disclosure.
Fig. 8 is a flowchart of separating out a DATA write signal and a DATA read signal by means of a slope triggering function of an oscilloscope in the present disclosure.
Fig. 9 is a result diagram of separating out the DATA write signal in the present disclosure;
Fig. 10 is a result diagram of separating out the DATA read signal in the present disclosure.
Fig. 11 is a block diagram of a data signal processing apparatus for an eMMC according to the present disclosure.

### Detailed Description

In order to make the above objectives, features, and advantages of the present disclosure more evident and readily understandable, the present disclosure is further described in detail below with reference to the accompanying drawings and specific embodiments.

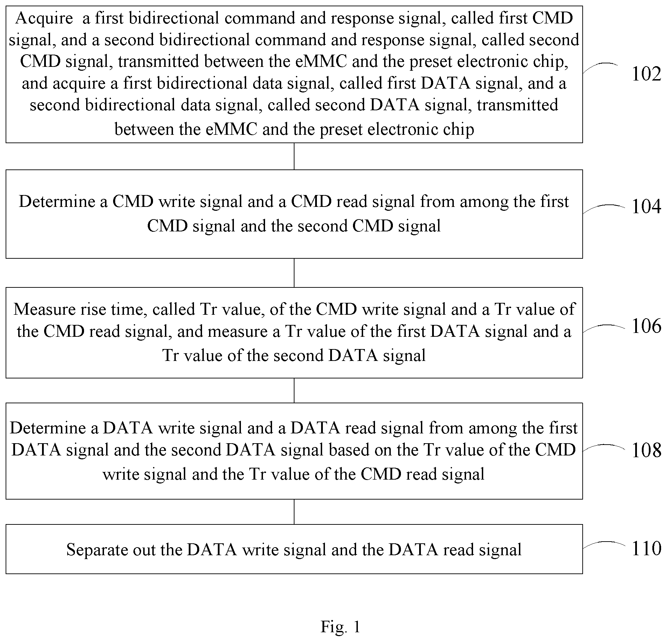

Refer to Fig. 1 which illustrates a flowchart of a data signal processing method for an eMMC according to the present disclosure. The eMMC is connected with a preset electronic chip. The method may specifically include the following steps.

In step 102, a first bidirectional command/response signal (first CMD signal) and a second bidirectional command/response signal (second CMD signal) transmitted between the eMMC and the preset electronic chip are acquired, and a first bidirectional data signal (first DATA signal) and a second bidirectional data signal (second DATA signal) transmitted between the eMMC and the preset electronic chip are acquired.

In an embodiment of the present disclosure, the preset electronic chip may include, but is not limited to, a central processing unit (CPU), a graphics processing unit (GPU), a communication baseband, etc.

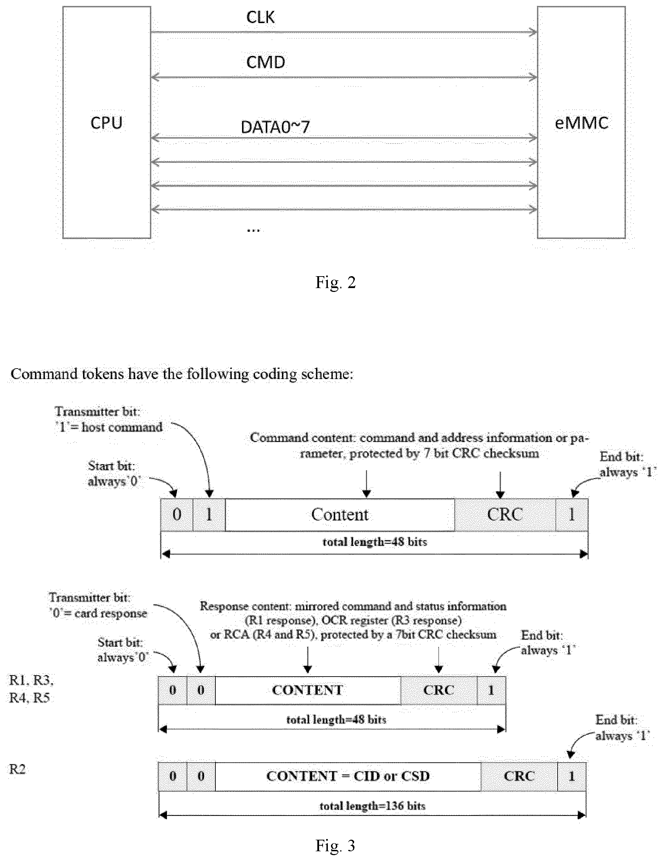

Refer to Fig. 2 which is a simplified signal flow graph of the eMMC of the present disclosure. In a practical application of an embodiment of the present disclosure, signals are communicated between the eMMC and the CPU, which include three types of signals, namely CLK, CMD, and DATA signals. The CLK signals are unidirectional, and the CMD signals and the DATA signals are bidirectional.

In step 104, a CMD write signal and a CMD read signal are determined from among the first CMD signal and the second CMD signal.

The first CMD signal and the second CMD signal are bidirectional command and response signals and form a frame of a complete CMD signal. A frame of a complete CMD signal includes sent and returned command signals. In an embodiment of the present disclosure, a direction of the command transmission is from the CPU to the eMMC, and a direction of the returned signal is from the eMMC to the CPU. In an embodiment of the present disclosure, the CMD write signal and the CMD read signal may be determined based on a frame structure of the first CMD signal and a frame structure of the second CMD signal.

Refer to Fig. 3 which is a schematic diagram of a frame structure of a CMD signal of the present disclosure. Step 104 may include the following sub-steps.

In sub-step S 1042, when a second bit in the frame structure of the first CMD signal is 1, it is determined that the first CMD signal is the CMD write signal.

When the second bit in the frame structure of the first CMD signal is 1, content in the frame structure of the first CMD signal represents that the signal is transmitted from the CPU to the eMMC, and it is determined that the first CMD signal is a CMD write signal.

In sub-step S1044, when the second bit in the frame structure of the first CMD signal is 0, it is determined that the first CMD signal is the CMD read signal.

When the second bit in the frame structure of the first CMD signal is 0, the content in the frame structure of the first CMD signal represents that the signal is returned from the eMMC to the CPU, and it is determined that the first CMD signal is a CMD read signal.

In sub-step S1046, when a second bit in the frame structure of the second CMD signal is 1, it is determined that the second CMD signal is the CMD write signal.

When the second bit in the frame structure of the second CMD signal is 1, content in the frame structure of the second CMD signal represents that the signal is transmitted from the CPU to the eMMC, and it is determined that the second CMD signal is a CMD write signal.

In sub-step S1048, when the second bit in the frame structure of the second CMD signal is 0, it is determined that the second CMD signal is the CMD read signal.

When the second bit in the frame structure of the second CMD signal is 0, the content in the frame structure of the second CMD signal represents that the signal is returned from the eMMC to the CPU, and it is determined that the second CMD signal is a CMD read signal.

In the existing technologies, those of ordinary skill in the art usually use eMMC consistency analysis software provided optional in an oscilloscope to determine the direction of a CMD signal for an eMMC. The principle behind it is to determine a CMD write signal or a CMD read signal from the message of the CMD signal. When the message of the CMD signal is CMD17 or CMD18, it means that the current operation is a read operation. When the message of the CMD signal is CMD30 or CMD31, it means that the current operation is a write operation. Optional accessories however need to be additionally purchased at a high price for the consistency analysis software for parsing the message of the CMD signal.

In the embodiments of the present disclosure, the CMD write signal and the CMD read signal are determined based on the frame structure of the first CMD signal and the frame structure of the second CMD signal, and it is not necessary to additionally purchase optional accessories for parsing messages of the CMD signals in order to determine the directions of the CMD signals for the eMMC. The embodiments of the present disclosure are thus advantageous in saving cost.

In step 106, a rise time value (Tr value) of the CMD write signal and a Tr value of the CMD read signal are measured, and a Tr value of the first DATA signal and a Tr value of the second DATA signal are measured.

Signals output from different chips are different in rise time, and directions of the signals can thus be determined based on the differences in the rise time. In the embodiments of the present disclosure, the eMMC and the CPU are two different chips. A signal output from the eMMC is a read signal, and a signal output from the CPU is a write signal. Specifically, when the CPU transmits a command signal to the eMMC and the CPU writes to the eMMC, in which case the signal output from the CPU is a write signal, and the signal input to the eMMC is a write signal. When the eMMC returns a command signal to the CPU or the CPU reads a signal from the eMMC, in which case the signal output from the eMMC is a read signal, and the signal input to the CPU is a read signal.

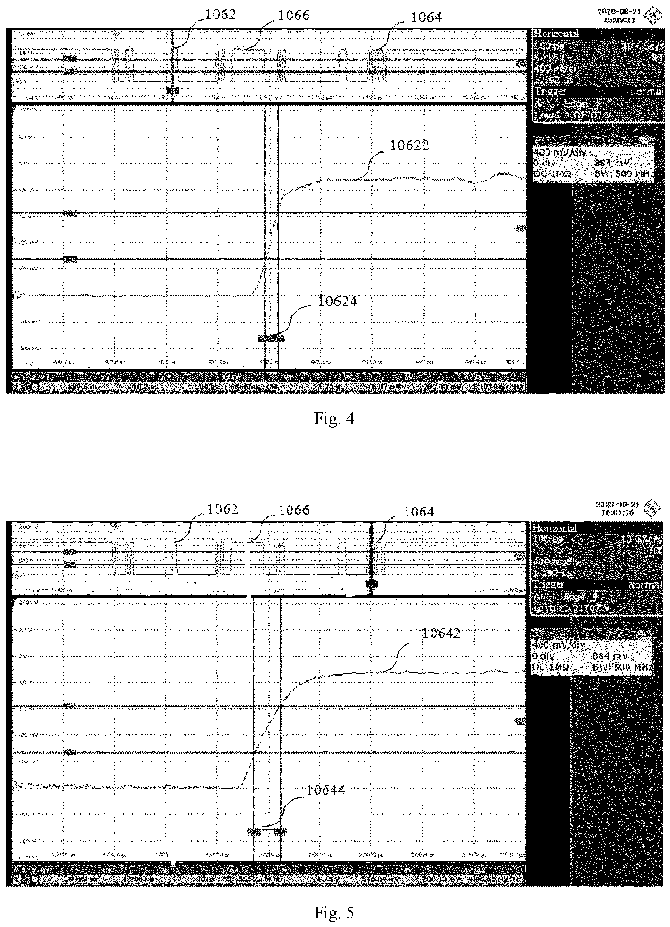

Refer to Fig. 4 which is a schematic diagram of measuring the Tr value of the CMD write signal in the present disclosure, and refer to Fig. 5 which is a schematic diagram of measuring the Tr value of the CMD read signal in the present disclosure. In an embodiment of the present disclosure, waveform 1062 is the CMD write signal; waveform 1064 is the CMD read signal; and waveform 1066 shows a transition in signal direction. Waveform 10622 is an enlarged view of part of the waveform 1062, and waveform 10642 is an enlarged view of part of the waveform 1064.

It should be noted that the rise time of a pulse signal refers to the time interval between an instant at which the instantaneous value of the pulse first reaches a specified lower limit and an instant at which the instantaneous value reaches a specified upper limit. Unless otherwise specified, the lower limit and the upper limit are 10% and 90% of the peak amplitude of the pulse, respectively. In the field of control, the rise time refers to the time taken by a response curve to first reach a steady-state value from the zero instant, and is usually defined as the time taken by the response curve to rise from 10% of the steady-state value to 90% of the steady-state value.

In an embodiment of the present disclosure, referring to Fig. 4, the Tr value of the CMD write signal is measured. The Tr value of the CMD write signal is indicated by reference numeral 10624 and is calculated as Δx = 0.6ns. The Tr value of the CMD write signal is recorded. Referring to Fig. 5, the Tr value of the CMD read signal is measured. The Tr value of the CMD read signal is indicated by reference numeral 10644 and is calculated as Δx = 1.8ns. The Tr value of the CMD read signal is recorded.

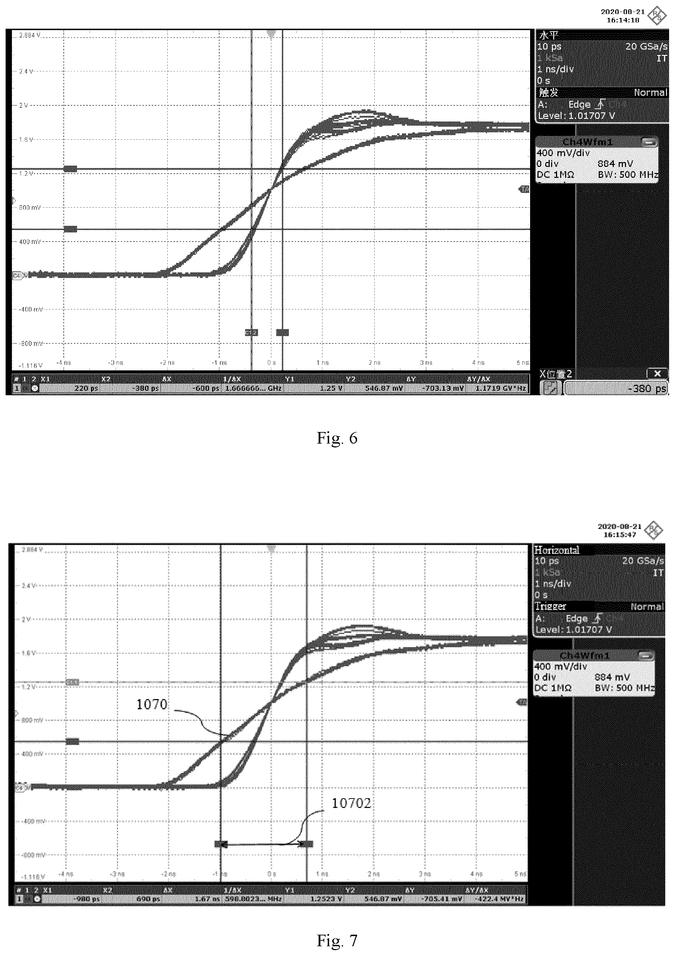

Refer to Fig. 6 which is a schematic diagram of measuring the Tr value of the first DATA signal in the present disclosure and Fig. 7 which is a schematic diagram of measuring the Tr value of the second DATA signal in the present disclosure. Waveforms of the DATA signals in two directions are superimposed. Waveform 1068 is the waveform of the first DATA signal, and waveform 1070 is the waveform of the second DATA signal. Since the DATA signals do not have a frame structure like that of the CMD signals, directions of the DATA signals cannot be determined solely from the frame structure of the DATA signals. For this reason, in an embodiment of the present disclosure, it is necessary to determine a DATA write signal and a DATA read signal from among the first DATA signal and the second DATA signal.

It should be noted that the rise time of a pulse signal refers to the time interval between an instant at which the instantaneous value of the pulse first reaches a specified lower limit and an instant at which the instantaneous value reaches a specified upper limit. Unless otherwise specified, the lower limit and the upper limit are 10% and 90% of the peak amplitude of the pulse, respectively. In the field of control, the rise time refers to the time taken by a response curve to first reach a steady-state value from the zero instant, and is usually defined as the time taken by the response curve to rise from 10% of the steady-state value to 90% of the steady-state value.

In an embodiment of the present disclosure, referring to Fig. 6, the Tr value of the first DATA signal is measured. The Tr value of the first DATA signal is indicated by reference numeral 10682 and is calculated as Δx = 0.6*ns.* The Tr value of the first DATA signal is recorded. Referring to Fig. 7, the Tr value of the second DATA signal is measured. The Tr value of the first DATA signal is indicated by reference numeral 10702 and is calculated as Δ*x* = 1.67*ns.* The Tr value of the second DATA signal is recorded.

In step 108, a DATA write signal and a DATA read signal are determined from among the first DATA signal and the second DATA signal based on the Tr value of the CMD write signal and the Tr value of the CMD read signal.

In an embodiment of the present disclosure, the Tr values of the CMD write signal and the CMD read signal are in a corresponding relationship in value sizes with the Tr values of the DATA write signal and the DATA read signal. This corresponding relationship is determined by two aspects. On the one hand, because pins for CMD signals and DATA signals of chips are I/O interfaces of the same type, the CMD signals and the DATA signals have same input and output characteristics. On the other hand, the design of hardware peripheral circuits of chips and the design of PCBs have same characteristics such as matched line length, 50 Ω impedance, parallel lines, etc. Therefore, in the embodiments of the present disclosure, the DATA write signal and the DATA read signal are determined based on the corresponding relationship. Specifically, step 108 may include the following sub-steps.

In sub-step S1082, when the Tr value of the CMD write signal is greater than the Tr value of the CMD read signal, it is determined, from among the first DATA signal and the second DATA signal, that the one with the greater Tr value is the DATA write signal and the one with the smaller Tr value is the DATA read signal.

In sub-step S1084, when the Tr value of the CMD read signal is greater than the Tr value of the CMD write signal, it is determined, from among the first DATA signal and the second DATA signal, that the one with the greater Tr value is the DATA read signal and the one with the smaller Tr value is the DATA write signal.

In the embodiments of the present disclosure, the Tr value of the CMD write signal is Δx = 0.6ns and the Tr value of the CMD read signal is Δx = 1.8*ns,* the Tr value of the CMD read signal being greater than the Tr value of the CMD write signal. For the Tr values of the first DATA signal and the second DATA signal, the Tr value of the first DATA signal is Δx = 0.6*ns* and the Tr value of the second DATA signal is Δx =1.67*ns*, the one with the greater Tr value being the second DATA signal and the one with the smaller Tr value being the first DATA signal. In this case, it is determined that the first DATA signal is a DATA write signal, and the second DATA signal is a DATA read signal.

In actual measurement, it is necessary to determine input and output directions of a DATA signal in order to accurately measure parameters in the input and output directions. Specifically, in actual measurement, it is necessary to determine the DATA write signal and the DATA read signal in order to accurately measure parameters about the DATA write signal and the DATA read signal.

In the existing technologies, those of ordinary skill in the art usually use eMMC consistency analysis software optionally provided in an oscilloscope to determine a direction of a DATA signal for an eMMC. The oscilloscope consistency analysis software integrates logic analysis functions which can be used to determine whether a current DATA signal is a read or write signal by parsing a CLK signal and a CMD signal. The consistency analysis software however needs to simultaneously measure three signals, i.e., CLK, CMD, DATA signals, which requires much effort. The embodiments of the present disclosure can determine the direction of a DATA signal without the need of logical analysis functions of consistency analysis software to parse content of the data.

In an embodiment of the present disclosure, after the CMD write signal and the CMD read signal are determined, the Tr value of the CMD write signal and the Tr value of the CMD read signal are measured, and the Tr value of the first DATA signal and the Tr value of the second DATA signal are measured. The DATA write signal and the DATA read signal are then determined based on the corresponding relationship in value size between Tr values of a CMD write signal and a CMD read signal and Tr values of a DATA write signal and a DATA read signal. In the embodiments of the present disclosure, the directions of the DATA signals are determined without requiring use of the logical analysis functions of the consistency analysis software to parse content of the data, which is convenient and efficient.

In step 110, the DATA write signal and the DATA read signal are separated out.

It should be noted that slope triggering is to set an oscilloscope to trigger on a positive slope or a negative slope in a specified time period which is set to be 20ns-10s. When a signal meets the set conditions, sampling will be triggered. A button may be selected and used to adjust LEVEL A, or LEVEL B, or both LEVEL A and LEVEL B.

Specifically, step 110 may include the following sub-steps.

In sub-step S 1102, the DATA write signal and the DATA read signal are separated out by means of slope triggering of an oscilloscope so as to obtain the DATA write signal and the DATA read signal separately.

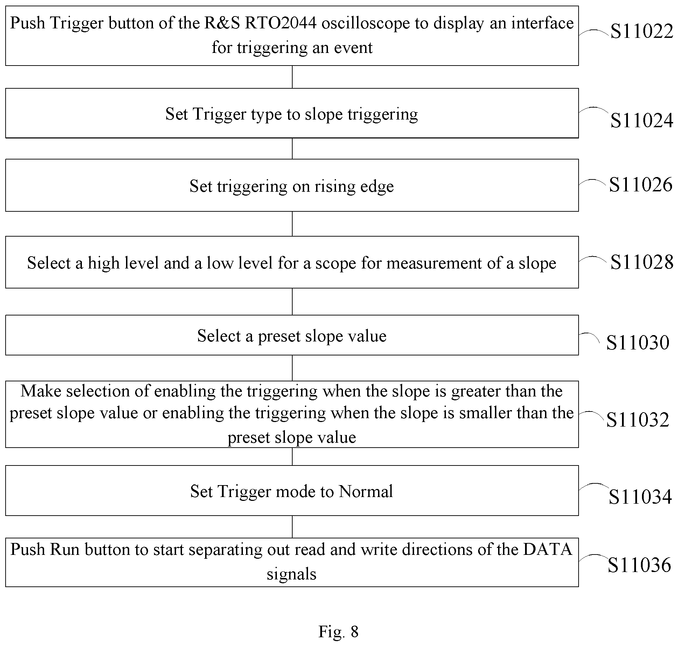

Refer to Fig. 8 which is a flowchart of separating out the DATA write signal and the DATA read signal by means of the slope triggering function of the oscilloscope in the present disclosure. Specifically, sub-step 1102 may include the following sub-steps.

In sub-step S11022, Trigger button of the R&S RTO2044 oscilloscope is pushed to display an interface for triggering an event.

In sub-step S11024, Trigger type is set to slope triggering.

In sub-step S11026, triggering on rising edge is set.

In sub-step S11028, a high level and a low level are selected for a scope for measurement of a slope.

In sub-step S11030, a preset slope value is selected.

In sub-step S11032, selection is made of enabling the triggering when the slope is greater than the preset slope value or enabling the triggering when the slope is smaller than the preset slope value.

In sub-step S11034, Trigger mode is set to Normal.

In sub-step S11036, Run button is pushed to start separating out read and write directions of the DATA signals.

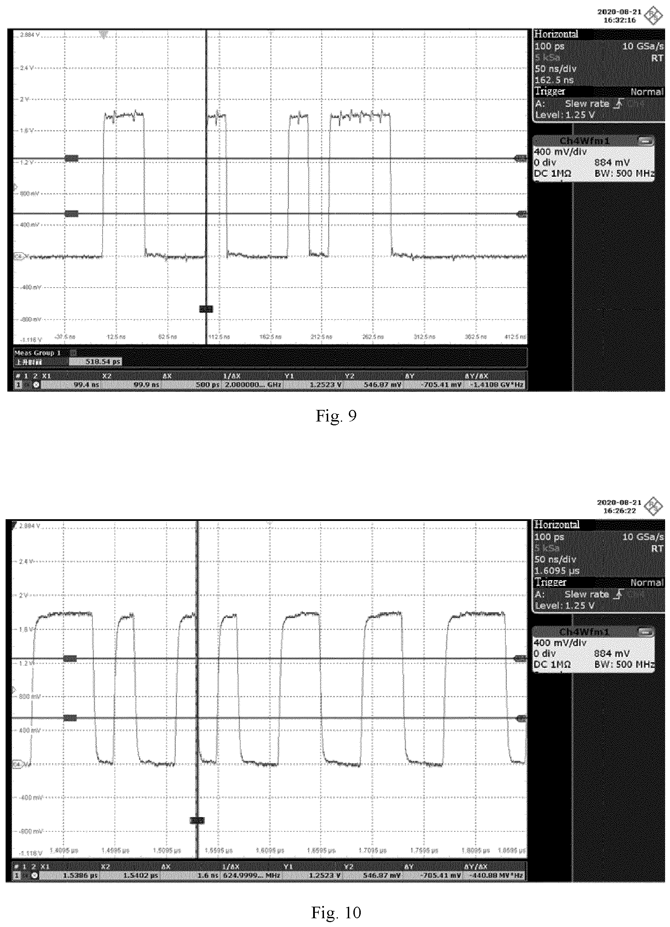

Refer to Fig. 9 which is a result diagram of separating out the DATA write signal in the present disclosure, and refer to Fig. 10 which is a result diagram of separating out the DATA read signal in the present disclosure. In the embodiments of the present disclosure, the DATA write signal and the DATA read signal are separated out separately by enabling the slope triggering of the oscilloscope.

In the embodiments of the present disclosure, a first CMD signal and a second CMD signal transmitted between an eMMC and a preset electronic chip may be obtained, and a first DATA signal and a second DATA signal transmitted between the eMMC and the preset electronic chip may be obtained. A CMD write signal and a CMD read signal are then determined from among the first CMD signal and the second CMD signal. After Tr values of the CMD write signal and the CMD read signal are measured and Tr values of the first DATA signal and the second DATA signal are measured, a DATA write signal and a DATA read signal are determined from among the first DATA signal and the second DATA signal based on the Tr values of the CMD write signal and the CMD read signal. the DATA write signal and the DATA read signal are then separated out. In the embodiments of the present disclosure, determination of the directions of the DATA signals does not need analyzing the content of the data by using logic analysis functions of paid consistency analysis software. The method according to the embodiments of the present disclosure thus has advantages of being simple, efficient, and cost-effective.

It should be noted that, for the sake of conciseness, the method embodiments are described herein as a series of combinations of actions. Those of ordinary skill in the art however should appreciate that the embodiments of the present disclosure are not limited by the described order of the actions, for some steps in the embodiments of the present disclosure can be performed in other order or performed simultaneously. Those of ordinary skill in the art should also appreciate that the embodiments described in the specification are preferred embodiments, and the actions involved in these embodiments are not necessarily a must for embodiments of the present disclosure.

The embodiments of the present disclosure further provide a data signal processing apparatus for an eMMC. The eMMC is connected with a preset electronic chip. The apparatus includes the following modules.

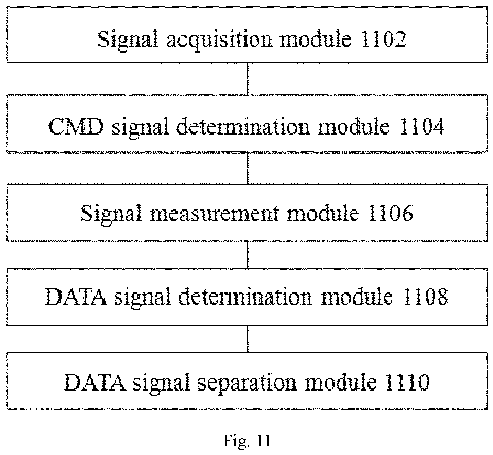

Referring to Fig. 11 which is a block diagram of the data signal processing apparatus for an eMMC according to the present disclosure, the apparatus may include the following modules: a signal acquisition module 1102, a CMD signal determination module 1104, a signal measurement module 1106, a DATA signal determination module 1108, and a DATA signal separation module 1110.

The signal acquisition module 1102 is configured to acquire a first CMD signal and a second CMD signal transmitted between the eMMC and the preset electronic chip, and acquire a first DATA signal and a second DATA signal transmitted between the eMMC and the preset electronic chip.

The CMD signal determination module 1104 is configured to determine a CMD write signal and a CMD read signal from among the first CMD signal and the second CMD signal.

The signal measurement module 1106 is configured to measure a Tr value of the CMD write signal and a Tr value of the CMD read signal, and measure a Tr value of the first DATA signal and a Tr value of the second DATA signal.

The DATA signal determination module 1108 is configured to determine a DATA write signal and a DATA read signal from among the first DATA signal and the second DATA signal based on the Tr value of the CMD write signal and the Tr value of the CMD read signal.

The DATA signal separation module 1110 is configured to separate out the DATA write signal and the DATA read signal.

In an embodiment of the present disclosure, the DATA signal determination module 1108 includes a first DATA signal determination sub-module and a second DATA signal determination sub-module.

The first DATA signal determination sub-module is configured to determine, from among the first DATA signal and the second DATA signal, that the one with the greater Tr value is the DATA write signal and the one with the smaller Tr value is the DATA read signal, when the Tr value of the CMD write signal is greater than the Tr value of the CMD read signal.

The second DATA signal determination sub-module is configured to determine, from among the first DATA signal and the second DATA signal, that the one with the greater Tr value is the DATA read signal and the one with the smaller Tr value is the DATA write signal, when the Tr value of the CMD read signal is greater than the Tr value of the CMD write signal.

In an embodiment of the present disclosure, the CMD signal determination module 1104 includes the following sub-modules: a first CMD signal determination sub-module, a second CMD signal determination sub-module, a third CMD signal determination sub-module, and a fourth CMD signal determination sub-module.

The first CMD signal determination sub-module is configured to determine that the first CMD signal is the CMD write signal, when a second bit in a frame structure of the first CMD signal is 1.

The second CMD signal determination sub-module is configured to determine that the first CMD signal is the CMD read signal, when the second bit in the frame structure of the first CMD signal is 0.

The third CMD signal determination sub-module is configured to determine that the second CMD signal is the CMD write signal, when a second bit in a frame structure of the second CMD signal is 1.

The fourth CMD signal determination sub-module is configured to determine that the second CMD signal is the CMD read signal, when the second bit in the frame structure of the second CMD signal is 0.

In an embodiment of the present disclosure, the DATA signal separation module 1110 includes a first DATA signal separation sub-module and a second DATA signal separation sub-module.

The first DATA signal separation sub-module is configured to separate out the DATA write signal.

The second DATA signal separation sub-module is configured to separate out the DATA read signal.

In the embodiments of the present disclosure, a first CMD signal and a second CMD signal transmitted between an eMMC and a preset electronic chip may be obtained, and a first DATA signal and a second DATA signal transmitted between the eMMC and the preset electronic chip may be obtained; a CMD write signal and a CMD read signal are then determined from among the first CMD signal and the second CMD signal; after Tr values of the CMD write signal and the CMD read signal are measured and Tr values of the first DATA signal and the second DATA signal are measured, a DATA write signal and a DATA read signal are determined from among the first DATA signal and the second DATA signal based on the Tr values of the CMD write signal and the CMD read signal; and finally the DATA write signal and the DATA read signal are separated out. In the embodiments of the present disclosure, it is not necessary to parse the content of the data by using logic analysis functions of paid consistency analysis software in order to determine the directions of the DATA signals. The apparatus according to the embodiments of the present disclosure thus has advantages of being simple, efficient, and cost-effective.

The apparatus embodiments are substantially similar to the method embodiments and are therefore described in a simplified way. Reference can be made to the description of the method embodiments for relevant details.

The embodiments of the present disclosure further provide an electronic device including a memory and one or more programs. The one or more programs are stored in the memory and are executable by one or more processors to implement the data signal processing method for an eMMC as described in any of the embodiments of the present disclosure.

The embodiments of the present disclosure further provide a readable storage medium. When instructions in the storage medium are executed by a processor of an electronic device, the electronic device is caused to implement the data signal processing method for an eMMC as described in any of the embodiments of the present disclosure.

The embodiments in this specification are described in a progressive manner. Each embodiment highlights its differences from other embodiments. The embodiments can refer to each other for same and similar portions therebetween.

Those of ordinary skill in the art will appreciate that the embodiments of the present disclosure may be provided as methods, apparatuses, or computer program products. The embodiments of the present disclosure may thus take the form of complete hardware embodiments, complete software embodiments, or embodiments with combinations of software and hardware. Further, the embodiments of the present disclosure may take the form of computer program products implemented on one or more computer-usable storage media (including but not limited to disk memory, CD-ROM, optical memory, etc.) containing computer-usable program codes.

The embodiments of the present disclosure are described with reference to flowcharts and/or block diagrams of methods, terminal devices (systems), and computer program products according to the embodiments of the present disclosure. It should be appreciated that each step and/or block in the flowcharts and/or block diagrams, and a combination of steps and/or blocks in the flowcharts and/or block diagrams may be implemented by computer program instructions. These computer program instructions may be provided to a processing unit of a general-purpose computer, a special-purpose computer, an embedded processor, or other programmable data processing terminal devices to produce a machine, such that the instructions executed by the processing unit of the computer or other programmable data processing terminal devices produce an apparatus for implementing a specified function in one or more steps in a flowchart and/or one or more blocks in a block diagram.

These computer program instructions may also be stored in a computer-readable memory capable of guiding a computer or other programmable data processing terminal devices to work in a particular manner, such that the instructions stored in the computer-readable memory produce a manufactured product including an instruction device, the instruction device implementing a specified function in one or more steps in a flowchart and/or one or more blocks in a block diagram.

These computer program instructions may also be loaded onto a computer or other programmable data processing terminal devices, such that a series of operational steps are performed on the computer or other programmable terminal devices to produce computer-implemented processing, such that the instructions executed on the computer or other programmable terminal devices provide steps for implementing a specified function in one or more steps in a flowchart and/or one or more blocks in a block diagram.

Although preferred ones of embodiments of the present disclosure have been described, those of ordinary skill in the art, once knowing the basic inventive concepts, can make additional variations and modifications to these embodiments. The appended claims are therefore intended to be construed as including these preferred embodiments as well as all variations and modifications falling within the scope of the embodiments of the present disclosure.

Finally, it should be noted that, in this text, terms indicating relations such as "first", "second", and the like, are used only to distinguish one entity or operation from another, without necessarily requiring or implying that these entities or operations be/are provided in any such actual relation or order. Further, the terms "include", "comprise", "contain", or any other variants thereof are intended to cover non-exclusive inclusion, such that a process, a method, an article, or a terminal device including a list of elements includes not only those listed elements, but also other elements not expressly listed, or elements inherent to such a process, method, article, or terminal device. Without further limitation, an element as defined by the statement "including/comprising a ......" does not preclude the existence of any additional identical element in a process, a method, an article, or a terminal device including that element.

The above is a detailed description of the data signal processing method and apparatus, electronic device, and the readable storage medium provided by the present disclosure. Principles and embodiments of the present disclosure are illustrated herein by way of specific examples. The description of the above embodiments is only illustrative of the method of the present disclosure and its core concepts. Those of general skill in the art can make variations to the embodiments and its range of application based on the concepts of the present disclosure. In summary, the content of this specification should not be construed as a restriction on the present disclosure.

## Claims

1. A data signal processing method for an embedded multimedia card, called eMMC, wherein the eMMC is connected with a preset electronic chip, the method comprising:
acquiring a first bidirectional command/response signal, called first CMD signal, and a second bidirectional command/response signal, called second CMD signal, transmitted between the eMMC and the preset electronic chip, and acquiring a first bidirectional data signal, called first DATA signal, and a second bidirectional data signal, called second DATA signal, transmitted between the eMMC and the preset electronic chip;
determining a CMD write signal and a CMD read signal from among the first CMD signal and the second CMD signal;
measuring a rise time value, called Tr value, of the CMD write signal and a Tr value of the CMD read signal, and measuring a Tr value of the first DATA signal and a Tr value of the second DATA signal;
determining a DATA write signal and a DATA read signal from among the first DATA signal and the second DATA signal based on the Tr value of the CMD write signal and the Tr value of the CMD read signal; and
separating out the DATA write signal and the DATA read signal.

2. The method according to claim 1, wherein the step of determining a DATA write signal and a DATA read signal from among the first DATA signal and the second DATA signal based on the Tr value of the CMD write signal and the Tr value of the CMD read signal comprises:
determining, from among the first DATA signal and the second DATA signal, that the one with the greater Tr value is the DATA write signal and the one with the smaller Tr value is the DATA read signal, when the Tr value of the CMD write signal is greater than the Tr value of the CMD read signal; and
determining, from among the first DATA signal and the second DATA signal, that the one with the greater Tr value is the DATA read signal and the one with the smaller Tr value is the DATA write signal, when the Tr value of the CMD read signal is greater than the Tr value of the CMD write signal.

3. The method according to claim 1, wherein the step of determining a CMD write signal and a CMD read signal from among the first CMD signal and the second CMD signal comprises:
determining that the first CMD signal is the CMD write signal when a second bit in a frame structure of the first CMD signal is 1;
determining that the first CMD signal is the CMD read signal when the second bit in the frame structure of the first CMD signal is 0;
determining that the second CMD signal is the CMD write signal when a second bit in a frame structure of the second CMD signal is 1; and
determining that the second CMD signal is the CMD read signal when the second bit in the frame structure of the second CMD signal is 0.

4. The method according to claim 1, wherein the step of separating out the DATA write signal and the DATA read signal comprises:
separating out the DATA write signal and the DATA read signal by means of slope triggering of an oscilloscope so as to obtain the DATA write signal and the DATA read signal separately.

5. A data signal processing apparatus for an eMMC, wherein the eMMC is connected with a preset electronic chip, the apparatus comprising:
a signal acquisition module, configured to acquire a first CMD signal and a second CMD signal transmitted between the eMMC and the preset electronic chip, and acquire a first DATA signal and a second DATA signal transmitted between the eMMC and the preset electronic chip;
a CMD signal determination module, configured to determine a CMD write signal and a CMD read signal from among the first CMD signal and the second CMD signal;
a signal measurement module, configured measure a Tr value of the CMD write signal and a Tr value of the CMD read signal, and measure a Tr value of the first DATA signal and a Tr value of the second DATA signal;
a DATA signal determination module, configured to determine a DATA write signal and a DATA read signal from among the first DATA signal and the second DATA signal based on the Tr value of the CMD write signal and the Tr value of the CMD read signal; and
a DATA signal separation module, configured to separate out the DATA write signal and the DATA read signal.

6. The apparatus according to claim 5, wherein the DATA signal determination module comprises:
a first DATA signal determination sub-module, configured to determine, from among the first DATA signal and the second DATA signal, that the one with the greater Tr value is the DATA write signal and the one with the smaller Tr value is the DATA read signal, when the Tr value of the CMD write signal is greater than the Tr value of the CMD read signal; and
a second DATA signal determination sub-module, configured to determine, from among the first DATA signal and the second DATA signal, that the one with the greater Tr value is the DATA read signal and the one with the smaller Tr value is the DATA write signal, when the Tr value of the CMD read signal is greater than the Tr value of the CMD write signal.

7. The apparatus according to claim 5, wherein the CMD signal determination module comprises:
a first CMD signal determination sub-module, configured to determine that the first CMD signal is the CMD write signal when a second bit in a frame structure of the first CMD signal is 1;
a second CMD signal determination sub-module, configured to determine that the first CMD signal is the CMD read signal when the second bit in the frame structure of the first CMD signal is 0;
a third CMD signal determination sub-module, configured to determine that the second CMD signal is the CMD write signal when a second bit in a frame structure of the second CMD signal is 1; and
a fourth CMD signal determination sub-module, configured to determine that the second CMD signal is the CMD read signal when the second bit in the frame structure of the second CMD signal is 0.

8. The apparatus according to claim 5, wherein the DATA signal separation module comprises:
a first DATA signal separation sub-module, configured to separate out the DATA write signal; and
a second DATA signal separation sub-module, configured to separate out the DATA read signal.

9. An electronic device, comprising a memory and one or more programs, wherein the one or more programs are stored in the memory and are executable by one or more processors to implement the data signal processing method for an eMMC according to any of claims 1 to 4.

10. A readable storage medium having stored thereon instructions which, when executed by a processor of an electronic device, cause the electronic device to implement the data signal processing method for an eMMC according to any of claims 1 to 4.
